# FASCICULE DE BREVET EUROPEEN

(11) **EP 0 680 170 B1**
(45) Date de publication et mention de la délivrance du brevet: **19.12.2001**
(21) Numéro de dépôt: 95410036.8
(22) Date de dépôt: 25.04.1995
(51) Int. Cl.: H04L 7/033, H04L 7/02

(54) **Circuit de transmission d'un signal code en ligne sur une ligne téléphonique comprenant un synchroniseur de fréquence**
Übertragungsanordnung für ein Leitungskodiertes Signal über eine Fernsprechleitung mit Frequenzsynchronisierungsschaltung
Circuit for the transmission of a line-coded signal on a telephone line with a frequency synchroniser

(30) Priorité: 29.04.1994 FR 9405500
(43) Date de publication de la demande: 02.11.1995
(73) Titulaire: STMicroelectronics S.A., 92120 Montrouge (FR)
(72) Inventeur: Fensch, Thierry, F-38000 Grenoble (FR); Sevenhans, Jan, B-2930 Brasschaat (BE)
(74) Mandataire: de Beaumont, Michel

(56) Documents cités:
- WO-A-91/19371
- IEEE JOURNAL OF SOLID-STATE CIRCUITS., vol. 25, no. 6, 1 Décembre 1990 NEW YORK US, pages 1414-1425, XP 000176570 ROY BATRUNI ET AL. 'Mixed digital/analog signal processing for a single-chip 2B1Q U-interface transceiver. 176570'
- IEEE JOURNAL OF SOLID-STATE CIRCUITS., vol. 22, no. 2, 1 Avril 1987 NEW YORK US, pages 255-261, DEOG-KYOON JEONG ET AL. 'Design of PLL-based clock generation circuits.'
- NACHRICHTENTECHNISCHE BERICHTE, no. 5, 1 Novembre 1988 BACKNANG DE, pages 40-49, XP 000233875 VOLKER HESPELT ET AL. 'Zur Synchronisation des Empfängers für den ISDN-Basisanschluss'

## Description

La présente invention concerne un circuit de transmission à 160 kbits d'un signal codé sur une ligne téléphonique.

Un tel circuit de transmission est destiné à une transmission dite NUMERIS (transmission numérique à intégration de services) qui prévoit de faire circuler sur une ligne téléphonique bifilaire classique indifféremment de la parole, de l'image ou des données. Ce circuit est intégré à des cartes de terminaison de ligne des centraux téléphoniques en amont du transformateur de ligne, de part et d'autre de la ligne téléphonique. Le mode de transmission NUMERIS est basé sur un codage en ligne des informations qui sont transmises selon une norme dite 2B1Q à une fréquence de 80 kHz. Cette norme de transmission à 160 kbits/s comprend deux canaux à 64 kbits/s dits canaux B sur lesquels peuvent transiter indifféremment de la parole ou des données, un canal à 16 kbits/s dit canal D sur lequel peut transiter des données, les 16 kbits/s restants étant utilisés pour transmettre des mots de contraintes système.

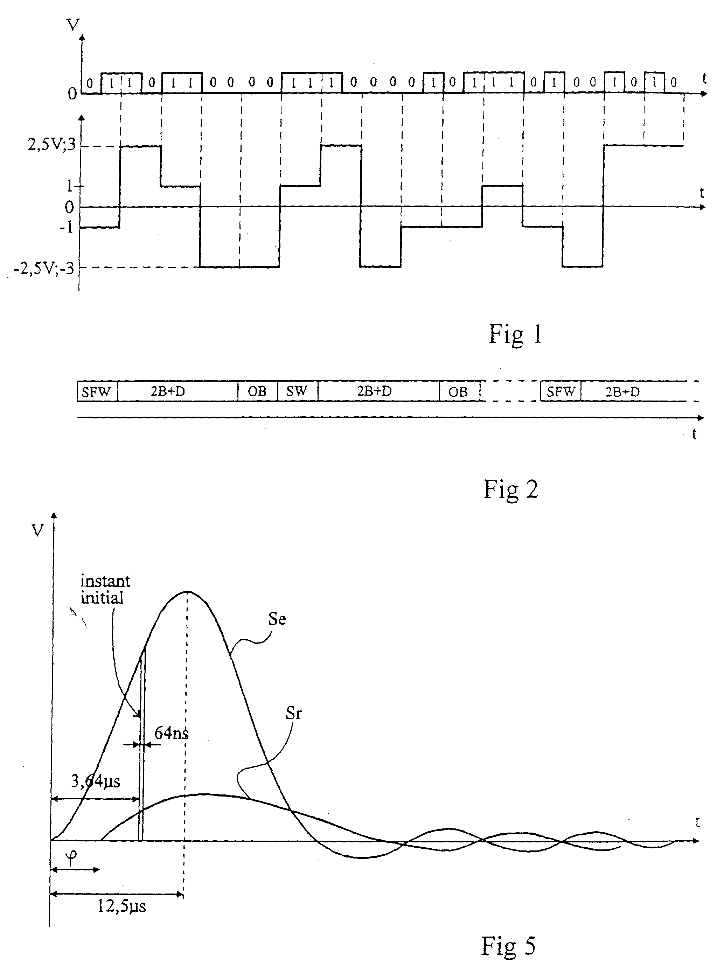

Le codage des informations selon la norme 2B1Q consiste à transformer deux codes binaires successifs en l'un des quatre niveaux d'un code quaternaire permettant ainsi un débit de 160 kbits/s à une fréquence de 80 kHz. La figure 1 montre, sous forme de chronogrammes, un exemple de codage réalisé selon la norme 2B1Q d'un signal binaire.

A chaque paire de bits successifs correspond l'un des 4 niveaux (3, 1, -1, -3) du code quaternaire selon le tableau suivant :

| | | | | |
|---|---|---|---|---|
| Codes binaires | 10 | 11 | 01 | 00 |
| Code quaternaire | +3 | +1 | -1 | -3 |

L'amplitude crête à crête du signal quaternaire est de 5 V pour une transmission NUMERIS. La fréquence utilisée étant de 80 kHz, chaque code quaternaire présente une largeur de 12,5 µs.

Les codes quaternaires sont transmis selon une trame comprenant successivement, comme le montre le chronogramme de la figure 2, un mot de synchronisation (SW) de 18 bits ou 9 codes quaternaires, 216 bits ou 108 codes quaternaires pour les informations (2B+D) correspondants aux deux canaux B et au canal D, ainsi que 6 bits ou 3 codes quaternaires (OB) comportant des indications nécessaires au décodage des données. Un mot de synchronisation dit de super-trame (SFW) est intercalé tous les 8 mots de synchronisation (SW). La représentation de la figure 2 n'est pas à l'échelle pour des raisons de clarté, la longueur d'un mot de données 2B+D étant en réalité beaucoup plus grande que celle d'un mot de synchronisation.

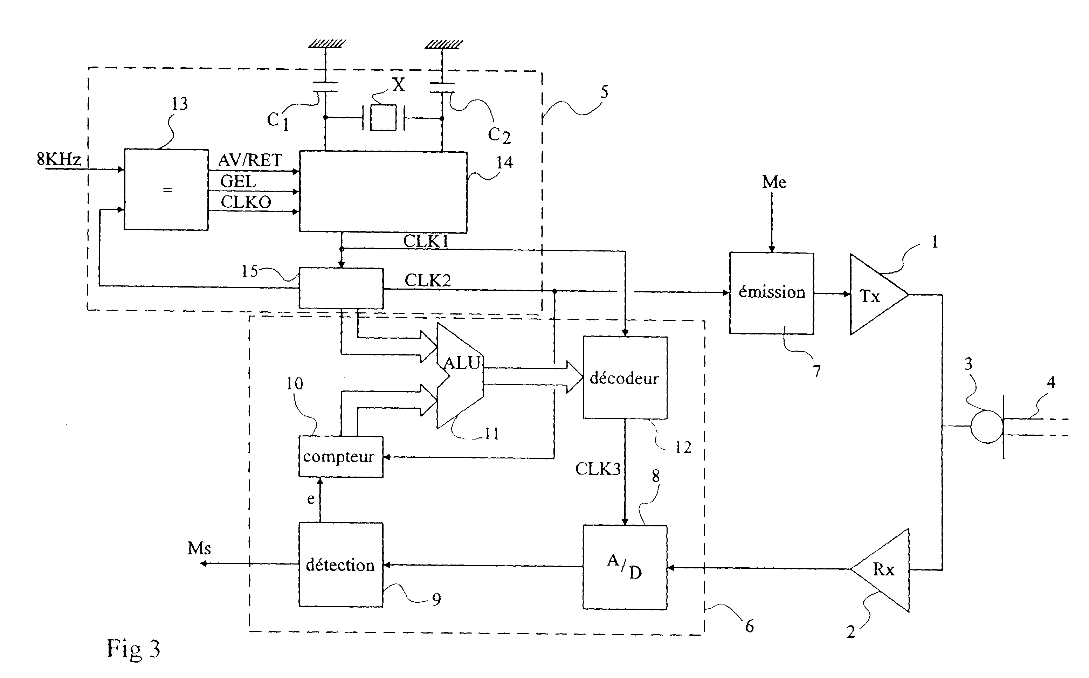

La figure 3 représente le schéma d'un circuit de transmission classique en mode 2B1Q. Un tel circuit est commercialisé par la demanderesse sous la dénomination ST5410.

Il comporte des organes d'émission (Tx) 1 et de réception (Rx) 2 proprement dits. Ils sont reliés respectivement par leur sortie et entrée à un transformateur de ligne 3 jouant le rôle d'une interface U entre ces organes 1 et 2 et une ligne téléphonique bifilaire 4. Le circuit comporte également, une boucle à verrouillage de phase (PLL) 5 synchronisée sur une fréquence de référence de 8 kHz disponible au niveau du central téléphonique, ainsi qu'une unité de réception 6 et une unité d'émission 7 de données.

L'unité d'émission de données 7 a pour rôle de transformer un message ("Me") en codes quaternaires en un signal analogique de fréquence 80 kHz, modulé en amplitude par le codage en ligne du message "Me" à transmettre.

L'unité de réception 6 comporte un convertisseur analogique/numérique (A/D) 8 échantillonné à une fréquence de 80 kHz ainsi qu'un circuit de détection des données reçues 9. Ce circuit 9 comporte un processeur de signal de type auto adaptatif, chargé d'éliminer l'écho dû à la transmission en duplex intégral sur la ligne et de restituer les informations sous forme binaire ("Ms"). L'unité de réception 6 comprend également un compteur de retard ligne 10, une unité arithmétique et logique (ALU) 11 et un décodeur 12 dont le fonctionnement sera explicité par la suite.

Du fait que la transmission s'effectue en duplex intégral, l'unité de réception 6 doit être capable de dissocier le signal émis avec une amplitude d'environ 5 V du signal reçu fortement atténué (de l'ordre de 40 dB) par la ligne et ne possédant plus qu'une amplitude d'environ 30 mV. Cette dissociation s'effectue sur la base du déphasage entre le signal émis et le signal reçu. Ce déphasage dépend de la configuration de la ligne et sa valeur initiale est mesurée par cette unité 6 pendant un régime transitoire d'établissement de la communication.

Un premier problème soulevé par ce type de transmission réside dans le besoin d'asservir la phase du signal d'échantillonnage en fonction du glissement temporel ou gigue du signal reçu en régime établi par rapport au déphasage initial mesuré lors du régime transitoire d'établissement de la communication. Cette gigue de phase est par exemple due à des variations de température sur la ligne.

Un second problème réside dans le besoin d'échantillonner le signal au voisinage de son pic pour éviter une confusion entre une information et un écho en raison de la faible amplitude des signaux reçus.

Ces contraintes conduisent, à disposer d'une horloge de fréquence élevée par rapport au signal d'échantillonnage à 80 kHz pour permettre de positionner les fronts du signal d'échantillonnage au voisinage des pics du signal reçu. De plus, toutes les horloges du circuit doivent être synchronisées sur la fréquence de référence de 8 kHz disponible au niveau du central téléphonique.

Pour ce faire, le circuit représenté à la figure 3 comporte, au sein de sa boucle de verrouillage de phase 5, une unité de comparaison et de filtre de boucle 13 dont une première entrée reçoit un signal d'horloge de référence à 8 kHz. Ce module 13 délivre vers un circuit synchroniseur de fréquence 14, d'une part un signal carré d'horloge à 8 kHz (CLK0) et d'autre part deux signaux indicateurs du résultat de la comparaison entre la fréquence de référence et un signal d'horloge à 8 kHz resynthétisé par la boucle à verrouillage de phase et envoyé sur la seconde entrée de l'unité de comparaison 13. Le premier signal est un signal (AV/RET) indicateur de l'avance ou du retard du signal d'horloge à 8 kHz resynthétisé. Le second signal est un signal (GEL) indicateur du verrouillage de la boucle, c'est-à-dire de l'existence ou non d'un déphasage entre les deux entrées de l'unité de comparaison 13.

Le circuit synchroniseur de fréquence 14 reçoit, outre les trois signaux AV/RET, GEL, et CLK0, un signal d'horloge délivré par une cellule à quartz constituée de deux condensateurs C1 et C2 et d'un quartz X à 15,36 MHz. Ce circuit 14 a pour rôle de délivrer un signal CLK1 à 15,36 MHz synchronisé sur la fréquence de 8 kHz (CLK0).

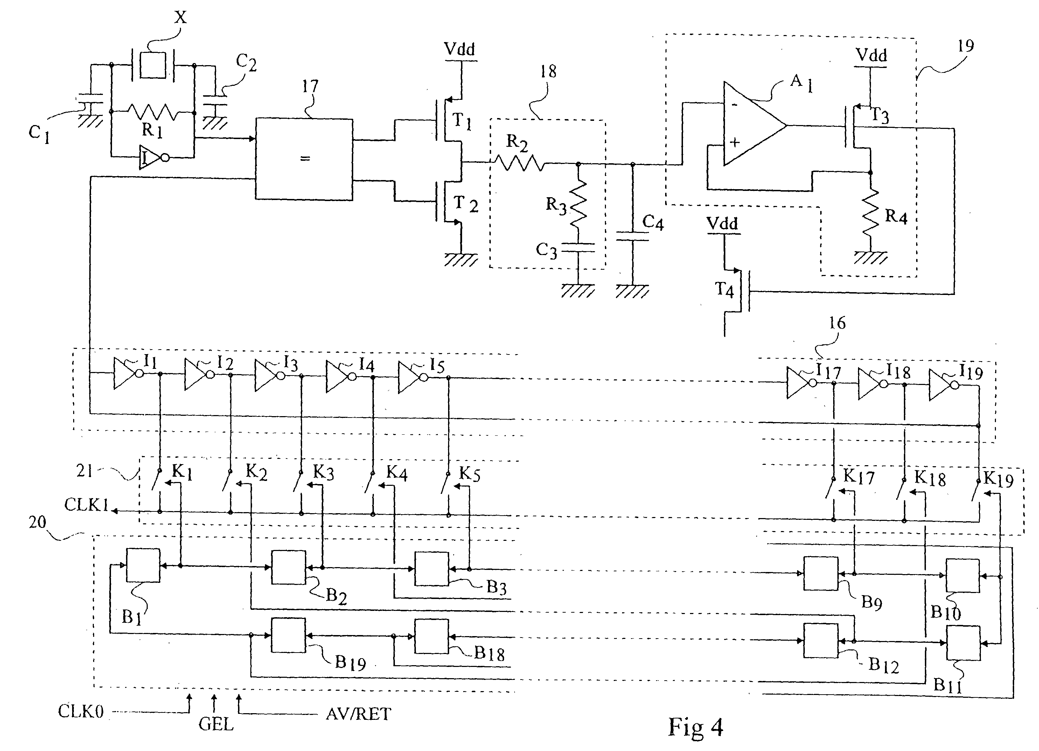

Le détail de la constitution du circuit 14 est représenté schématiquement à la figure 4. Il comporte un oscillateur en anneau 16, à 19 étages. L'oscillateur 16 comporte donc 19 inverseurs I(i), la sortie d'un inverseur I(i) étant reliée à l'entrée de l'inverseur suivant I(i+1) et la sortie du dernier inverseur I(19) étant reliée à l'entrée du premier I(1). Cet oscillateur en anneau est asservi en fréquence et en phase sur l'horloge délivrée par le quartz X, par une boucle à asservissement de phase qui sera décrite ci-après.

Cette boucle à asservissement de phase comporte un comparateur 17 dont une première entrée reçoit un signal d'horloge à 15,36 MHz issu de la cellule à quartz. Les deux bornes du quartz X sont en fait mises en parallèle avec une résistance R1 et un inverseur I à la sortie duquel est prélevé le signal d'horloge à 15,36 MHz. Une seconde entrée du comparateur 17 reçoit le signal issu du dernier inverseur I(19) de l'oscillateur 16. L'une ou l'autre des deux sorties du comparateur 17, selon le sens du déphasage entre les entrées, fournit un signal dont la durée est fonction de l'amplitude du déphasage. Chacune de ces sorties est reliée à la grille de transistors MOS, respectivement T1 et T2, le transistor MOS T1 étant à canal P et le transistor MOS T2 à canal N. La source du transistor T1 est connectée à une tension d'alimentation haute "Vdd". La source du transistor T2 est connectée à une tension d'alimentation basse (la masse). Le drain commun des transistors T1 et T2 est connecté, par l'intermédiaire d'un montage de filtre de boucle 18 constitué de résistances R2 et R3 et d'un condensateur C3, à la première borne d'un condensateur C4 dont la deuxième borne est à la masse. Ainsi, le condensateur C4 se charge ou se décharge selon le sens du déphasage aux entrées du comparateur 17. La tension sur le condensateur C4 est convertie en courant par un convertisseur tension-courant 19. Ce convertisseur comprend, par exemple, un amplificateur opérationnel AI, une résistance R4 et un transistor MOS canal P T3 montés en série entre la tension d'alimentation Vdd et la masse, l'ensemble étant connecté de la façon représentée. Le courant traversant le transistor MOS T3 est recopié par des transistors MOS à canal P T4, utilisés pour polariser les inverseurs I(i) de l'oscillateur en anneau 16. Le système se stabilise quand la fréquence et la phase de l'oscillateur en anneau 16 concordent avec celles de l'oscillateur à quartz.

Le recours à un oscillateur en anneau à 19 étages est lié au retard moyen d'environ 3,4 ns apporté par chaque inverseur I(i), dans le cadre d'une technologie de fabrication particulière, ce qui permet de retrouver la période de 65 ns correspondant à la fréquence de 15,36 MHz.

La synchronisation de la fréquence de 15,36 MHz sur le signal CLK0 à 8 kHz s'effectue au moyen d'un registre à décalage 20 de type à "1" circulant. Ce registre est utilisé pour sélectionner la sortie de l'inverseur I(i) sur lequel sera prélevé le signal CLK1. Le registre à décalage 20 est piloté par le signal d'horloge CLK0 à 8 kHz. Il est initialisé avec un "1" dans une de ses 19 bascules B(j), les autres bascules étant initialisées à "0", et la commande du décalage est effectuée par les signaux AV/RET et GEL du comparateur 13. L'état de chacune des bascules B(j) est envoyé pour commander un interrupteur K(i) d'un multiplexeur 21 qui sélectionne la sortie de l'inverseur I(i) sur laquelle est prélevée le signal CLK1.

En fait, les états de deux bascules voisines B(j) et B(j+1) sont envoyés pour commander deux interrupteurs K(i), K(i+2) non voisins. De la sorte, le signal CLK1 est retardé, respectivement avancé, de 6,8 ns (correspondant au temps de propagation de deux inverseurs de l'anneau 16) à chaque fois que le "1" circulant est décalé d'une bascule B(j) à une bascule voisine B(j+1), respectivement B(j-1).

On va maintenant reprendre la description de la figure 3. Le signal CLK1 issu du circuit synchroniseur 14 est envoyé sur l'entrée d'un compteur 8 bits 15 paramètré pour fonctionner en diviseur par 192. Ce compteur 15 délivre ainsi un signal d'horloge de 80 kHz (CLK2) synchronisé sur la fréquence de 8 kHz. Ce signal CLK2 constitue l'horloge d'émission de l'unité d'émission de données 7, ainsi que l'horloge du compteur de retard ligne 10 de l'unité de réception de données 6.

Le compteur 10 contient, sur 8 bits, le reflet du déphasage entre les informations émises et les informations reçues. Il est initialisé lors du régime transitoire d'établissement de la communication sur la valeur initiale de ce déphasage essentiellement lié à la longueur de la ligne. Puis, en régime établi, il corrige cette valeur lorsque se produit une erreur de phase par rapport à ce déphasage initial. Pour ce faire, il est commandé en comptage/décomptage par un signal d'erreur de phase "e" délivré par le circuit de détection 9. Ce signal "e" représente en fait la validation du comptage/décomptage dès que le processeur de signal du circuit 9 détecte, en régime établi, un glissement du signal reçu par rapport à la valeur du déphasage précédemment contenue dans le compteur 10. La fréquence du comptage/décomptage correspond au huitième de la fréquence de 80 kHz, soit 10 kHz, la valeur du compteur 10 est donc susceptible de changer toutes les 0,1 ms. Le compteur de retard ligne 10 est en pratique un compteur 16 bits dont seuls 8 sont utilisés pour les besoins du circuit.

La valeur du compteur 10 est "ajoutée" par l'ALU 11 aux 8 bits issus du compteur 15. Comme cette valeur ne change pas pendant les 192 pas de 65 ns du compteur 15 (correspondant à la fréquence de 80 kHz), l'ALU 11 contient, pour chaque état du compteur 15, donc toutes les 65 ns, la valeur du déphasage contenue dans le compteur 10.

Le résultat sur 9 bits de l'ALU 11 est délivré au décodeur 12 qui est piloté par le signal d'horloge CLK1 à 15,36 MHz. Le décodeur 12 a pour rôle de délivrer le signal d'échantillonnage (CLK3) à 80 kHz au convertisseur A/D 8. La largeur des impulsions d'échantillonnage est fixée par la fréquence de 15,36 MHz qui pilote le décodeur 12, elle est donc de 65 ns. Le signal d'échantillonnage CLK3 se trouve de plus déphasé par rapport au signal CLK2 de la valeur contenue dans le compteur 10 et répercutée par l'ALU 11 sur chaque état du compteur 15.

Si l'état du compteur 10 change de 1, chaque état de l'ALU 11 change de 1. Le décodeur 12 produit donc un saut de phase d'une amplitude de 65 ns (correspondant à la fréquence de 15,36 MHz) sur la phase du signal d'échantillonnage CLK3. Le sens du saut de phase est fixé par le signe du signal "e" qui place le compteur 10 soit en comptage soit en décomptage.

Pour permettre au convertisseur A/D 8 d'échantillonner correctement le signal afin que le processeur de signal qui réalise la fonction d'annulation d'écho fonctionne correctement, le décodeur 12 cale le signal d'échantillonnage sur la détection des états 56 et 248 des signaux issus de l'ALU 11. Cela revient à dire que pour un code reçu à la fréquence de 80 kHz, donc d'une largeur de 12,5 µs, l'échantillonnage s'effectue à 56*65 ns soit 3,64 µs du début du code. Cette valeur est ainsi fixée pour le bon fonctionnement du processeur de signal qui réalise la fonction d'annulation d'écho.

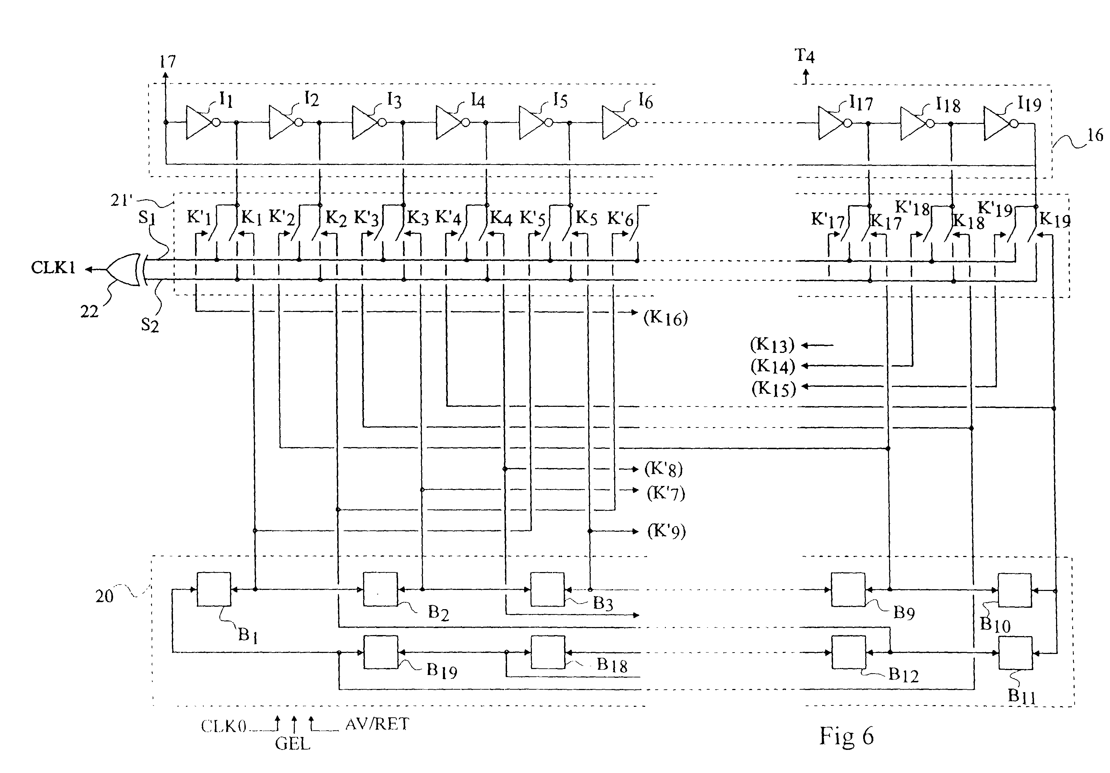

La figure 5 illustre sous forme de chronogramme, sans respect d'échelle pour des raisons de clarté, la position d'un code reçu "Sr" par rapport à la position d'un code émis "Se". Le déphasage entre les deux signaux a une valeur ϕ. Les impulsions du signal d'échantillonnage présentent une largeur de 64 ns (correspondant à la fréquence de 15,36 MHz). Les pics de ces impulsions sont positionnés à ϕ + 3,64 µs du début du code émis.

Un inconvénient de ce type de circuit réside dans le fait que l'amplitude des sauts de phase de la fréquence d'échantillonnage est trop importante pour permettre une détection optimale par le processeur de signal. En effet, à l'apparition d'une erreur de phase, plus l'amplitude du saut de phase est importante, plus il y a un risque que le convertisseur A/D 8 échantillonne le code en cours de réception à une mauvaise valeur et induise une erreur dans la restitution du message.

Un exemple d'un tel circuit de transmission est décrit dans l'article "Mixed Digital/Analog Signal Processing for a Single-Chip 2B1Q U-Interface Transceiver" de R. Batruni et al. dans IEEE Journal of Solid-State Circuits, vol. 25, N° 6, décembre 1990.

Un objet de la présente invention est de pallier à cet inconvénient en permettant une réduction de l'amplitude des sauts de phase tout en introduisant un minimum de modification dans le circuit de transmission.

Un autre inconvénient réside dans le fait que les sauts de phase du signal d'échantillonnage sont provoqués sur n'importe quel code quaternaire reçu selon la trame 2B1Q. Ces sauts de phase sont susceptibles de générer des erreurs d'interprétation des données par le processeur de signal et donc des erreurs dans la communication. Le processeur de signal qui réalise l'annulation d'écho ayant besoin de plusieurs bauds pour reconverger de manière optimale, il s'ensuit que l'erreur risque de concerner plusieurs codes. En effet, un saut de phase faisant diverger le processeur de signal sur un code quaternaire d'un des canaux de données risque, non seulement d'entraîner une erreur d'interprétation de ce code en raison du décalage de la position de l'échantillonnage sur ce code, mais également des codes suivants jusqu'à ce le processeur reconverge correctement.

Un autre objet de la présente invention est donc de pallier à cet inconvénient en permettant un positionnement des sauts de phase dans la trame 2B1Q, sans pour autant avoir recours à d'autres composants que ceux qui constituent le circuit existant.

Pour atteindre ces objets, la présente invention prévoit un circuit de transmission en duplex intégral d'un signal codé en ligne selon une trame alternant essentiellement mots de synchronisation et mots de données, comportant une boucle de verrouillage de phase propre à délivrer un signal d'horloge d'émission synchronisé sur une fréquence de référence, du type comprenant un synchroniseur de fréquence comportant un oscillateur en anneau de reproduction d'une fréquence délivrée par un oscillateur et un compteur/diviseur de fréquence ; un signal d'échantillonnage d'un convertisseur analogique/numérique, asservi en phase sur le déphasage entre le signal émis et le signal reçu, étant produit, côté réception, sur la base d'un signal d'horloge fourni à un décodeur, par ledit oscillateur en anneau dont la fréquence fixe l'amplitude des sauts de phase éventuels du signal d'échantillonnage, et comportant des moyens propres à adjoindre audit synchroniseur de fréquence, une fonction de multiplieur de la fréquence délivrée par l'oscillateur en anneau de façon à réduire l'amplitude des sauts de phase éventuels du signal d'échantillonnage.

Selon un mode de réalisation de l'invention, lesdits moyens comportent notamment une porte logique propre à réaliser une combinaison de type "Ou Exclusif" de deux signaux, déphasés l'un par rapport à l'autre et issus de l'oscillateur en anneau dudit circuit synchroniseur et multiplieur de fréquence.

Selon un mode de réalisation de l'invention, la sélection du déphasage entre les deux sorties dudit oscillateur en anneau est effectuée au moyen d'un multiplexeur commandé par un registre à décalage du type à état "1" circulant.

Selon un mode de réalisation de l'invention, ledit oscillateur en anneau comporte n inverseurs, polarisés par un courant issu d'une boucle à asservissement de phase sur un signal délivré par un quartz ; ledit multiplexeur comporte deux séries de n interrupteurs, prélevant chacun respectivement une sortie de l'oscillateur en anneau, la commande d'un interrupteur de la première série, prélevant le signal de sortie de l'oscillateur sur un inverseur, étant confondue avec la commande d'un interrupteur de la seconde série qui prélève le signal de sortie de l'oscillateur sur un inverseur présentant avec le signal un retard correspondant au temps de propagation du signal dans m inverseurs ; et ledit registre à décalage comporte n bascules, l'état de deux bascules voisines constituant respectivement le signal de commande, dans chacune des séries, de deux interrupteurs non voisins, de sorte que le signal d'horloge délivré par la porte logique présente une fréquence égale au double de la fréquence du quartz.

Selon un mode de réalisation de l'invention, ledit registre à décalage est piloté par le signal d'horloge de référence, et le décalage de l'état "1" d'une bascule vers une bascule suivante ou précédente est commandé par un signal issu d'un comparateur de ladite boucle de verrouillage de phase, de sorte à synchroniser le signal d'horloge du décodeur sur le signal d'horloge de référence.

Selon un mode de réalisation de l'invention, le décodeur délivre au convertisseur analogique/numérique ledit signal d'échantillonnage sur la base du résultat fourni par une unité arithmétique et logique qui réalise la sommation de la valeur dudit compteur/diviseur de fréquence de ladite boucle à verrouillage de phase avec la valeur d'un compteur de retard ligne, ce dernier contenant la valeur du déphasage entre le signal émis et le signal reçu et sa fréquence de comptage/décomptage correspondant à la périodicité des mots de synchronisation de la trame.

Selon un mode de réalisation de l'invention, ledit compteur de retard ligne reçoit sur son entrée d'horloge un signal présentant, à chaque mot de synchronisation, une impulsion de largeur correspondant à la largeur d'un code reçu, la fréquence d'apparition de cette impulsion correspondant à la fréquence des mots de synchronisation sur la trame, et sur son entrée de comptage/décomptage, un signal indicateur de la présence et du sens d'une erreur de phase, ces deux signaux étant délivrés par un circuit de détection des données reçues.

Selon un mode de réalisation de l'invention, ladite impulsion dudit signal d'horloge du compteur de retard ligne est envoyée à l'apparition du premier code de chaque mot de synchronisation.

Selon un mode de réalisation de l'invention, le circuit est appliqué à la transmission à 160 kbits/s d'un signal codé en ligne en codes quaternaires selon la norme 2B1Q.

Selon un mode de réalisation de l'invention, ledit oscillateur en anneau comporte 19 inverseurs, ledit multiplexeur et ledit registre à décalage comportant, respectivement, deux séries de 19 interrupteurs, et 19 bascules, et le déphasage entre les deux signaux correspondant au temps de propagation dans 4 inverseurs ; les fréquences d'émission et d'échantillonnage sont de 80 kHz, la fréquence du signal d'horloge dudit décodeur étant de 30,72 MHz ; et la fréquence du signal d'horloge délivré par le circuit de détection est de l'ordre de 666,6 Hz, la largeur des impulsions d'échantillonnage et des sauts de phase étant de 32,5 ns.

Le fait, selon la présente invention, d'adjoindre au circuit synchroniseur de fréquence une fonction de multiplication de fréquence, permet de délivrer au décodeur une fréquence de 30,72 MHz et ainsi de réduire de moitié l'amplitude des sauts de phase de la fréquence d'échantillonnage.

De surcroît, ce résultat est atteint moyennant des modifications mineures du circuit dans la mesure où essentiellement seul le multiplexeur est modifié.

Une telle conformation a également pour effet de réduire de moitié la largeur des impulsions d'échantillonnage ce qui améliore encore la fiabilité de détection du circuit de transmission.

Le fait, selon la présente invention, d'alimenter le compteur de retard ligne par une horloge calée par le circuit de détection sur l'apparition d'un mot de synchronisation permet que les sauts de phase, en régime établi, soient positionnés sur la trame 2B1Q au niveau des mots de synchronisation. On évite ainsi tout saut de phase pendant les trois mots d'information 2B+D contenant des données, ce qui limite considérablement les erreurs de transmission.

Le choix du positionnement des sauts de phase sur les mots de synchronisation est motivé par le fait que ce champ est beaucoup moins sensible. En effet, il faut détecter six mots de synchronisation erronés successifs pour que le circuit se désynchronise et, en pratique, l'apparition d'un saut de phase en régime établi ne peut se produire que toutes les 10 trames, donc tous les 10 mots de synchronisation.

On dispose donc d'une marge de sécurité nettement suffisante pour éviter toute désynchronisation, tout en supprimant les risques d'erreur d'interprétation des données.

Le fait de caler l'horloge du compteur de retard ligne sur le premier code quaternaire du mot de synchronisation optimise cette sécurité. En effet, le processeur de signal ayant besoin de plusieurs bauds pour reconverger de manière optimale, on évite ainsi le risque qu'il termine sa convergence sur le début d'un mot de données. Le processeur dispose des 8 codes suivants du mot de synchronisation qui en comporte 9 pour reconverger, ce qui en pratique est suffisant.

On parvient donc, au moyen de la présente invention, à optimiser le fonctionnement du circuit, sans pour cela en augmenter sensiblement le nombre de composants, donc le coût.

Ces objets, caractéristiques et avantages ainsi que d'autres de la présente invention seront exposés en détail dans la description suivante d'un mode de réalisation particulier faite à titre non limitatif en relation avec les figures jointes parmi lesquelles :
les figures 1 à 5 décrites précédemment sont destinées à exposer l'état de la technique et le problème posé ;
la figure 6 représente partiellement un circuit synchroniseur et multiplieur de fréquence selon la présente invention ;
la figure 7 montre, sous forme de chronogrammes, la corrélation entre les principaux signaux du circuit synchroniseur et multiplieur de la figure 6 ;
la figure 8 représente un circuit de transmission, selon la présente invention, d'un signal à 160 kbits conformément à la trame 2B1Q ; et
la figure 9 montre, de façon schématique, sous forme de chronogrammes, la position des sauts de phase suivant le circuit de la figure 8.

Sur les figures 3, 4, 6 et 8, les mêmes éléments ont été désignés par les mêmes références.

Selon un premier aspect de la présente invention, le multiplexeur 21 de la figure 4 est remplacé par un multiplexeur 21'. Comme le montre la figure 6, le multiplexeur 21' est désormais de type à deux sorties S1 et S2, toutes deux délivrant un signal à une fréquence de 15,36 MHz prélevé sur l'oscillateur en anneau 16. Ces deux sorties S1 et S2 sont décalées l'une par rapport à l'autre de 13,6 ns correspondant au temps de propagation de quatre inverseurs. En effet, l'état d'une bascule B(j) du registre 20 est utilisé non seulement pour commander un interrupteur K(i) d'une première série et délivrer un signal de sortie S1 prélevé sur un inverseur I(i) comme précédemment, mais également pour commander un autre interrupteur K'(i+4) d'une deuxième série qui délivre un second signal S2 prélevé cette fois sur la sortie d'un inverseur I(i+4). Ces deux signaux S1 et S2 sont envoyés sur une porte logique "Ou Exclusif" (EXOR) 22 qui délivre sur sa sortie le signal CLK1. Pour des raisons de clarté, seuls l'oscillateur en anneau 16, le multiplexeur 21' et le registre à décalage 20 ont été représentés sur cette figure. La boucle à asservissement de phase de polarisation de l'oscillateur en anneau 16 n'est pas modifiée par rapport à la représentation de la figure 4.

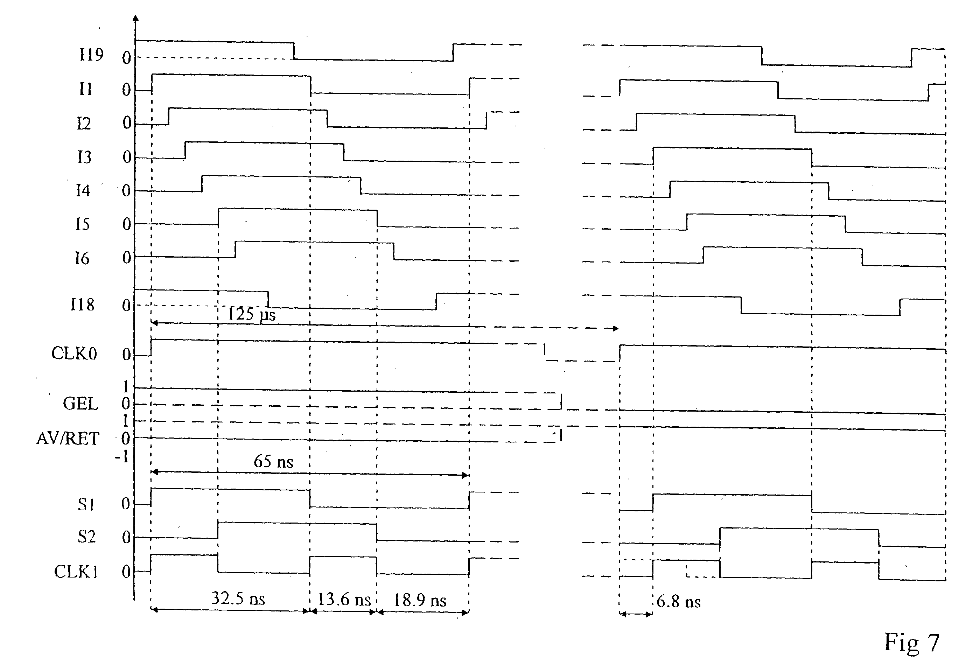

Sur la figure 7 ont été représentés, les chronogrammes des sorties des inverseurs I(i), les chronogrammes des signaux S1 et S2 de sortie du multiplexeur 21', et le chronogramme du signal CLK1. On suppose tout d'abord que le "1" circulant du registre à décalage 20 est présent dans la bascule B(1) puis, sous l'effet d'une impulsion positive du signal AV/RET issu du comparateur 13, qu'il est présent dans la bascule B(2). La fréquence de décalage du registre 20 étant fixée par l'horloge CLK0 de façon à maintenir la synchronisation sur le signal à 8 kHz, le déphasage du signal CLK1 ne s'effectue, en cas de besoin, que toutes les 12,5 µs.

Comme on peut le voir sur cette figure, le signal CLK1 correspond tout d'abord à la combinaison logique "Ou Exclusif" des signaux de sortie des inverseurs I(1) et I(5), qui sont respectivement commandés par les interrupteurs K(1) et K'(5). Le circuit synchroniseur et multiplieur 14' reste dans cette configuration jusqu'à l'apparition d'une impulsion du signal AV/RET et la remise au repos du signal GEL. L'impulsion du signal AV/RET étant positive, le "1" circulant se déplace de la bascule B(1) vers la bascule B(2), ce qui provoque alors l'ouverture des interrupteurs K(1) et K'(5) et la fermeture des interrupteurs K(3) et K'(7). Par suite, le signal CLK1 correspond désormais à la combinaison des signaux de sortie des inverseurs I(3) et I(7). Le signal CLK1 se trouve alors retardé de 6,8 ns, ce qui va avoir pour effet de retarder la fréquence de 8 kHz resynthétisée par le compteur 15' pour qu'elle se recale en phase sur la fréquence de référence de 8 kHz du central téléphonique.

Selon l'invention, l'ALU 11' réalise désormais la sommation sur 9 bits des signaux reçus du compteur 15' et du compteur de retard ligne 10'. Le compteur 15' dispose d'un étage supplémentaire de sorte qu'il devient un compteur sur 9 bits et qu'il se comporte en diviseur par 384 pour délivrer le signal CLK2 à 80 kHz. Pour ce qui est du compteur de retard ligne 10', on utilise un bit supplémentaire pour qu'il compte sur 9 bits. L'ALU ajoute donc désormais à chaque état du compteur 15' la valeur contenue dans le compteur 10'. Le signal CLK1 est envoyé, comme précédemment en guise de signal d'horloge au décodeur 12, mais il est d'une fréquence de 30,72 MHz. Le décodeur 12 détecte désormais les états 112 et 496, ce qui a pour effet, en cas de saut de phase, d'effectuer des sauts d'une amplitude de 32,5 ns. Les impulsions d'échantillonnage du convertisseur A/D 8 présentent quant à elles une largeur de 32,5 ns.

On pourrait également ne pas rajouter d'étage au compteur 15 et lui envoyer, comme signal d'horloge, le signal S1 du circuit synchroniseur et multiplicateur 14'. Il se comporterait alors comme précédemment en compteur/diviseur par 192. Cela aurait pour conséquence de conserver des sauts de phase d'échantillonnage d'une amplitude de 32,5 ns, fixée par le signal CLK1, mais de maintenir une largeur des impulsions d'échantillonnage de 65 ns.

En raison du temps de propagation de chaque inverseur I(i), le signal CLK1 n'est pas un signal carré mais présente des impulsions de largeur de 13,6 ns correspondant au temps de propagation de quatre inverseurs I(i). Son temps de repos, étant fixé par différence sur la fréquence de 15,36 MHz, est donc de 18,9 ns. Cela ne présente pas d'inconvénient dans la mesure où seuls les fronts montant du signal d'horloge CLK1 sont utilisés pour les besoins du circuit de transmission.

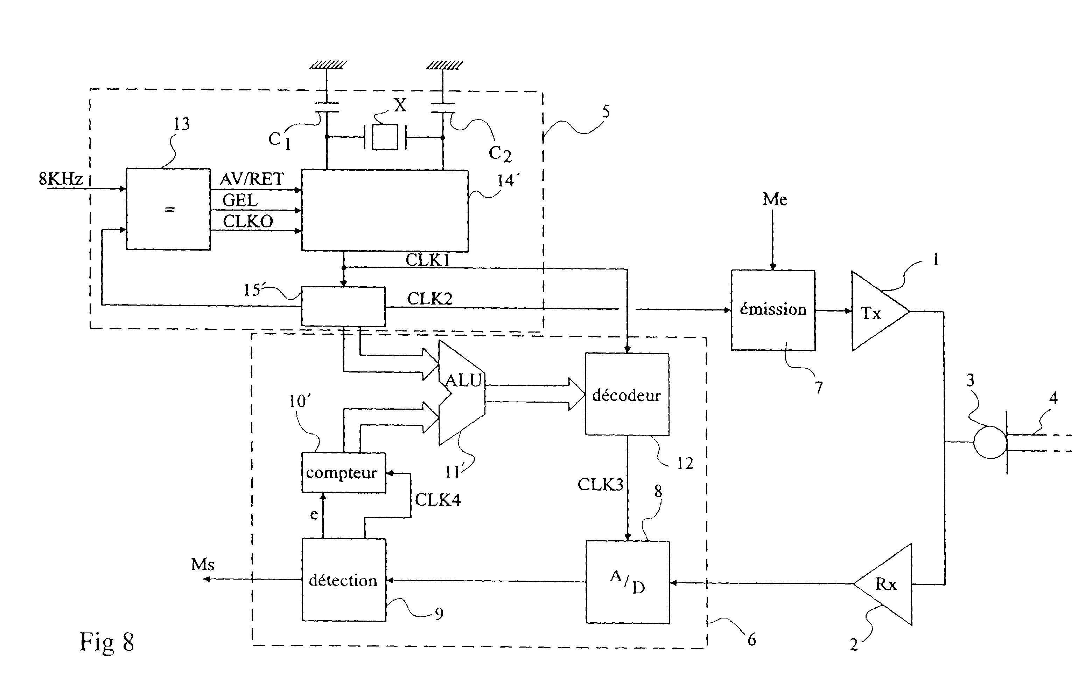

Selon un deuxième aspect de la présente invention, comme le représente la figure 8, l'entrée d'horloge du compteur de ligne à retard 10' reçoit un signal CLK4 issu du circuit de détection 9. Ce signal CLK4 est calé sur la détection du premier code quaternaire des mots de synchronisation. En d'autres termes, le circuit de détection 9 envoie une impulsion à chaque premier code quaternaire d'un mot de synchronisation qu'il soit simple ou de super-trame, la largeur de l'impulsion étant fixée par la fréquence de 80 kHz, elle est donc de 12,5 µs. L'émission de ce signal ne pose aucun problème au niveau du circuit de détection 9 dans la mesure où son rôle est précisément de décoder le signal reçu et que l'on dispose donc en son sein de la trame décodée.

Un premier code d'un mot de synchronisation se reproduisant sur la trame tous les 120 codes, la fréquence d'apparition de ce premier code du mot de synchronisation est de 1,5 ms, ce qui donne pour le compteur 10', une fréquence d'horloge et donc une fréquence de comptage d'environ 666,6 Hz.

Le signal d'erreur de phase "e" présente une valeur nulle, positive ou négative, en fonction de l'absence ou de la présence (avance ou retard) d'une erreur de phase. Il place donc le compteur 10' respectivement en position inhibée, en position de comptage ou de décomptage. A chaque impulsion d'horloge CLK4, la valeur contenue dans le compteur 10' est ainsi soit maintenue, soit incrémentée, soit décrémentée suivant la valeur du signal "e".

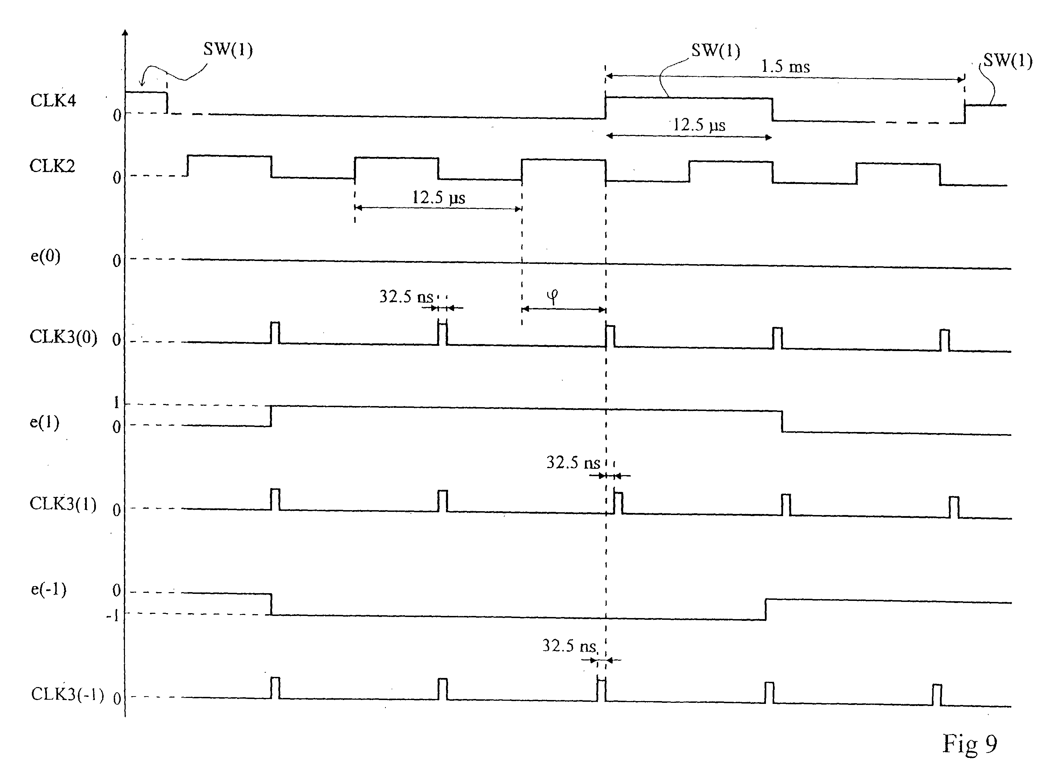

La figure 9 illustre sous forme de chronogrammes la forme des signaux CLK4 et CLK2, puis celle des signaux "e" et CLK3, respectivement en l'absence d'erreur de phase, en présence d'une avance de phase, et en présence d'un retard de phase. Pour les besoins du tracé, la valeur initiale du déphasage ϕ entre le signal émis et le signal reçu est prise dans cet exemple à 180° de sorte qu'en l'absence d'erreur de phase le signal CLK3(0) soit en phase avec le signal CLK2. La représentation de la figure 6 n'est pas à l'échelle pour des raisons de clarté.

Comme on peut le voir sur la figure 9, le signal CLK4 présente une impulsion de 12,5 µs de large à chaque premier code SW(1) d'un mot de synchronisation, la période de ces impulsions étant de 1,5 ms. Le signal CLK2 correspond quant à lui à l'horloge d'émission à 80 kHz et présente donc une période de 12,5 µs.

Le premier signal d'erreur représenté e(0) est un signal d'absence d'erreur de phase. De la sorte, le signal CLK3(0) constituant le signal d'échantillonnage à 80 kHz avec des impulsions d'une largeur de 32,5 ns est déphasé de ϕ par rapport à l'horloge d'émission CLK2.

En cas de retard de phase du signal reçu par rapport à cette valeur initiale, le signal d'erreur e(1) présente un front montant au moment de la détection de cette erreur de phase et place donc le compteur de retard ligne 10' en position de comptage. Mais comme l'horloge de ce compteur est fournie par le signal CLK4, le compteur ne va être incrémenté de 1 que lors de l'apparition de l'impulsion d'horloge suivante correspondant à l'arrivée du premier code SW(1) d'un mot de synchronisation. Le signal CLK3(1) est alors décalé d'une valeur de 32,5 ns correspondant à la fréquence d'horloge de 30,72 MHz du décodeur 12.

En cas d'avance de phase du signal reçu par rapport à la valeur initiale, le signal d'erreur e(-1) présente un front descendant au moment de sa détection et place le compteur de retard ligne 10' en position de décomptage. Comme dans le cas précédent, le compteur n'est décrémenté de 1 que lors de l'apparition d'une impulsion sur le signal CLK4, et le signal CLK3(-1) est alors décalé dans le sens inverse.

Dans les deux cas e(1) et e(-1), le signal "e" retrouve la valeur nulle dès que l'erreur de phase a disparu, c'est-à-dire dès que la valeur du compteur 10' correspond au déphasage actuel entre le signal émis et le signal reçu.

Bien entendu, la présente invention est susceptible de diverses variantes et modifications qui apparaîtront à l'homme de l'art. En particulier, chacun des composants décrits pourra être remplacé par un ou plusieurs éléments remplissant la même fonction.

## Revendications

1. Circuit de transmission en duplex intégral d'un signal codé en ligne selon une trame alternant essentiellement mot de synchronisation (SW) et mots de données (2B+D), comportant une boucle de verrouillage de phase (5) propre à délivrer un signal d'horloge d'émission (CLK2) synchronisé sur une fréquence de référence (CLK0), du type comprenant un synchroniseur de fréquence et un compteur/diviseur de fréquence ; un signal d'échantillonnage (CLK3) d'un convertisseur analogique/numérique (8), asservi en phase sur le déphasage (ϕ) entre le signal émis et le signal reçu, étant produit, côté réception, sur la base d'un signal d'horloge (CLK1) fourni à un décodeur (12), par ledit synchroniseur de la boucle (5), **caractérisé en ce qu'**il comporte des moyens propres à adjoindre audit synchroniseur de fréquence, une fonction de multiplieur de fréquence de façon à réduire l'amplitude des sauts de phase éventuels du signal d'échantillonnage (CLK3), lesdits moyens comportant notamment une porte logique (22) propre à réaliser une combinaison de type "Ou Exclusif" de deux signaux (S1, S2), déphasés l'un par rapport à l'autre, et issus d'un oscillateur en anneau (16) dudit circuit synchroniseur et multiplieur de fréquence (14'), la sélection du déphasage entre les deux sorties (S1, S2) dudit oscillateur en anneau (16) étant effectuée au moyen d'un multiplexeur (21').

2. Circuit de transmission selon la revendication 1, **caractérisé en ce que** ledit multiplexeur est commandé par un registre à décalage (20) du type à état "1" circulant.

3. Circuit de transmission selon la revendication 2, **caractérisé en ce que** ledit oscillateur en anneau (16) comporte n inverseurs (I(1)... I(i)... I(n)), polarisés par un courant issu d'une boucle à asservissement de phase sur un signal délivré par un quartz (X) ; **en ce que** ledit multiplexeur (21') comporte deux séries de n interrupteurs (K(1)... K(i)... K(n) ; K'(1)... K'(i)... K'(n)), prélevant chacun respectivement une sortie (S1 ; S2) de l'oscillateur en anneau (16), la commande d'un interrupteur (K(i)) de la première série, prélevant le signal de sortie SI de l'oscillateur (16) sur un inverseur (I(i)), étant confondue avec la commande d'un interrupteur (K'(i+m)) de la seconde série qui prélève le signal de sortie (S2) de l'oscillateur (16) sur un inverseur (I(i+m)) présentant avec le signal (S1) un retard correspondant au temps de propagation du signal dans m inverseurs ; et **en ce que** ledit registre à décalage (20) comporte n bascules (B(1)... B(j)... B(n)), l'état de deux bascules voisines (B(j), B(j+1)) constituant respectivement le signal de commande, dans chacune des séries, de deux interrupteurs (K(i), K(i+m/2) ; K'(i+m), K'(i+m+m/2)) non voisins, de sorte que le signal d'horloge (CLK1) délivré par la porte logique (22) présente une fréquence égale au double de la fréquence du quartz (X).

4. Circuit de transmission selon la revendication 2 ou 3, **caractérisé en ce que** ledit registre à décalage est piloté par le signal d'horloge de référence (CLK0) ; et **en ce que** le décalage de l'état "1" d'une bascule (B(j)) vers une bascule suivante (B(j+1)), ou précédente (B(j-1)), est commandé par un signal (AV/RET) issu d'un comparateur (13) de ladite boucle de verrouillage de phase (5), de sorte à synchroniser le signal d'horloge (CLK1) du décodeur (12) sur le signal d'horloge de référence (CLK0).

5. Circuit de transmission selon l'une quelconque des revendications 1 à 4, **caractérisé en ce que** le décodeur (12) délivre au convertisseur analogique/numérique (8) ledit signal d'échantillonnage (CLK3) sur la base du résultat fourni par une unité arithmétique et logique (11') qui réalise la sommation de la valeur dudit compteur/diviseur de fréquence (15') de ladite boucle à verrouillage de phase (5) avec la valeur d'un compteur de retard ligne (10'), ce dernier contenant la valeur du déphasage (ϕ) entre le signal émis et le signal reçu et sa fréquence de comptage/décomptage correspondant à la périodicité des mots de synchronisation (SW) de la trame.

6. Circuit de transmission selon la revendication 7, **caractérisé en ce que** ledit compteur de retard ligne (10') reçoit sur son entrée d'horloge, un signal (CLK4) présentant, à chaque mot de synchronisation (SW), une impulsion de largeur correspondant à la largeur d'un code reçu, la fréquence d'apparition de cette impulsion correspondant à la fréquence des mots de synchronisation (SW) sur la trame, et sur son entrée de comptage/décomptage, un signal ("e") indicateur de la présence et du sens d'une erreur de phase, ces deux signaux (CLK4, "e") étant délivrés par un circuit de détection des données reçues (9).

7. Circuit de transmission selon la revendication 6, **caractérisé en ce que** ladite impulsion dudit signal (CLK4) d'horloge du compteur de retard ligne (10') est envoyée à l'apparition du premier code (SW(1)) de chaque mot de synchronisation (SW).

8. Circuit de transmission selon l'une quelconque des revendications 1 à 7, **caractérisé en ce qu'**il est appliqué à la transmission à 160 kbits/s d'un signal codé en ligne en codes quaternaires selon la norme 2B1Q.

9. Circuit de transmission selon la revendication 8, **caractérisé en ce que** ledit oscillateur en anneau (16) comporte 19 inverseurs, ledit multiplexeur (21') et ledit registre à décalage (20) comportant, respectivement, deux séries de 19 interrupteurs, et 19 bascules, et le déphasage entre les deux signaux (S1, S2) correspondant au temps de propagation dans 4 inverseurs (I(i)) ; **en ce que** les fréquences d'émission (CLK2) et d'échantillonnage (CLK3) sont de 80 kHz, la fréquence du signal d'horloge (CLK1) dudit décodeur (12) étant de 30,72 MHz ; et **en ce que** la fréquence du signal d'horloge (CLK4) délivré par le circuit de détection (9) est de l'ordre de 666,6 Hz, la largeur des impulsions d'échantillonnage et des sauts de phase étant de 32,5 ns.

## Patentansprüche

1. Schaltung zur integralen bzw. Voll- Duplex-Übertragung eines Signals, das linear gemäß einem Rahmen kodiert ist, in welchem im wesentlichen ein Synchronisationswort (SW) und Datenwörter (2B+D) abwechseln, wobei die Übertragungsschaltung umfaßt eine Phasenverriegelungsschleife (5) zur Bildung eines auf einer Bezugsfrequenz (CLK0) synchronisierten Emissions- bzw. Sende- Taktsignals (CLK2), vom Typ mit einer Frequenz-Synchronisiervorrichtung und einem Frequenzzähler-und Teiler; ein Samplingsignal (CLK3) eines Analog/Digital-Wandlers (8), das in der Phase mit dem Phasenunterschied (ϕ) zwischen dem emittierten und dem Empfangssignal verriegelt ist und empfangsseitig auf der Grundlage eines von der genannten Synchronisiervorrichtung der Schleife (5) von einem Dekoder (12) zugeführten Taktsignals (CLK1) erzeugt wird, **dadurch gekennzeichnet, daß** die Schaltung Mittel aufweist, welche der genannten Frequenzsynchronisiervorrichtung eine Frequenzvervielfacherfunktion hinzufügen, um die Amplitude eventueller Phasensprünge des Samplingsignals (CLK3) zu verringern, wobei die genannten Mittel insbesondere ein Logikgatter (22) aufweisen zur Ausführung einer 'Exklusiv-ODER' - Verknüpfung von zwei Signalen (S1, S2), die gegeneinander in der Phase versetzt sind und aus einem Ringoszillator (16) der genannten Frequenzsynchronisier- und Vervielfacherschaltung (14') herrühren, wobei die Wahl der Phasenverschiebung zwischen den beiden Ausgangsgrößen (S1, S2) des Ringoszillators (16) mit Hilfe eines Multiplexers (21') erfolgt.

2. Übertragungsschaltung nach Anspruch 1, **dadurch gekennzeichnet, daß** der genannte Multiplexer durch ein Schieberegister (20) vom Typ mit umlaufenden Zustand '1' gesteuert wird.

3. Übertragungsschaltung nach Anspruch 2, **dadurch gekennzeichnet daß** der genannte Ringoszillator (16) n Inverter (I(1)...I(i)...I(n)) aufweist, die mit einem Strom vorgespannt werden, der von einer Schleife zur Phasenregelung auf der Grundlage eines von einem Quarz (X) gelieferten Signals erzeugt wird; daß der genannte Multiplexer (21') zwei Reihen von n Unterbrecherschaltern (K(1)..K(i)..K(n); K'(1)..K'(i)..K'(n)) aufweist, deren jeder jeweils eine Ausgangsgröße (S1; S2) des Ringzählers abnimmt, wobei die Steuerung eines Schalters (K(i)) der ersten Reihe, welcher das Ausgangssignal (S1) des Oszillators (16) an einem Inverter (I(i)) abnimmt, mit der Steuerung eines Schalters (K'(i+m)) der zweiten Reihe vereint wird, welcher das Ausgangssignal (S2) des Oszillators (16) an einem Inverter (I(i+m)) abnimmt, das gegenüber dem Signal (S1) eine Verzögerung entsprechend der Ausbreitungs- bzw. Fortpflanzungsdauer des Signals in m Invertern entspricht; und daß das genannte Schieberegister (20) n Kippstufen (B(1)..B(j)..B(n)) umfaßt, wobei der Zustand von zwei benachbarten Kippstufen (B(j), B(j+1)) jeweils das Steuersignal in jeder Reihe für zwei nicht benachbarte Schalter (K(i), K(i+m/2); K'(i+m), K(i+m+m/2) bildet, derart daß das von dem Logikgatter (22) abgegebene Taktsignal (CLK1) eine Frequenz gleich dem Doppelten der Frequenz des Quarz (X) aufweist.

4. Übertragungsschalter nach Anspruch 2 oder 3, **dadurch gekennzeichnet, daß** das genannte Schieberegister durch das Bezugstaktsignal (CLK0) gesteuert wird, und daß die Verschiebung des Zustands '1' von einer Kippstufe (B(j)) zu einer folgenden Kippstufe (B(j+1)) oder zu einer vorhergehenden Kippstufe (B(j-1)) durch ein von einem Komparator (13) der genannten Phasenverriegelungs-Schleife (5) geliefertes Signal (AV/RET) gesteuert wird, derart daß das Taktsignal (CLK1) des Dekoders (12) mit dem Bezugstaktsignal (CLK0) synchronisiert wird.

5. Übertragungsschaltung nach einem der Ansprüche 1 bis 4, **dadurch gekennzeichnet, daß** der Dekoder (12) dem Analog/Digital-Wandler (8) das genannte Samplingsignal (CLK3) auf der Grundlage eines von einer arithmetisch - logischen Einheit (ALU) (11') gelieferten Ergebnisses zuführt, welche die Summation des Betrags des genannten Zählers/Frequenzteilers (15') der genannten Phasenverriegelungsschleife (5) mit dem Betrag eines Leitungsverzögerungs-Zählers ausführt, wobei dieser letztere den Betrag der Phasenversetzung (ϕ) zwischen dem ausgesandten Signal und dem empfangenen Signal enthält und seine Aufwärts/Abwärts-Zählfrequenz der Periodizität der Synchronisationswörter (SW) des Rahmens entspricht.

6. Übertragungsschaltung nach Anspruch 7, **dadurch gekennzeichnet, daß** der genannte Leitungsverzögerungs-Zähler (10') an seinem Takteingang ein Signal (CLK4) zugeführt erhält, das bei jedem Synchronisationswort (SW) einen Impuls aufweist, dessen Breite der Breite eines empfangenen Codes entspricht, wobei die Frequenz, mit welcher dieser Impuls auftritt, der Frequenz der Synchronisationswörter (SW) in dem Rahmen entspricht, und daß der Leitungsverzögerungszähler (10') an seinem Auf-/Abwärtszähleingang ein Signal ('e') erhält, das eine Anzeige für das Vorliegen und den Richtungssinn eines Phasenfehlers bildet, wobei diese beiden Signale (CLK4, 'e') von einer Schaltung (9) zur Detektion der empfangenen Daten geliefert werden.

7. Übertragungsschaltung nach Anspruch 6, **dadurch gekennzeichnet, daß** der genannte Impuls des Taktsignals (CLK4) des Leitungsverzögerungs-Zählers (10') jeweils beim Auftreten des ersten Codes (SW(1)) jedes Synchronisationsworts (SW) ausgesandt wird.

8. Übertragungsschaltung nach einem der Ansprüche 1 bis 7, **dadurch gekennzeichnet, daß** sie zur 160 kbits/s - Übertragung eines linear in quaternären Codes nach der Norm 2B1Q kodierten Signals verwendet wird.

9. Übertragungsschaltung nach Anspruch 8, **dadurch gekennzeichnet, daß** der genannte Ringoszillator (16) 19 Inverter aufweist, daß der genannte Multiplexer (21') und das genannte Schieberegister (20) jeweils zwei Reihen von 19 Schaltern bzw. 19 Kippstufen umfaßt und die Phasenversetzung zwischen den beiden Signalen (S1, S2) der Fortpflanzungs- bzw. Ausbreitungszeit in 4 Invertern (I(i)) entspricht; daß die Emissionsfrequenzen (CLK2) und Samplingfrequenzen (CLK3) 80 kHz betragen, bei einer Frequenz des Taktsignals (CLK1) des genannten Dekoders (12) von 30,72 MHz; und daß die Frequenz des von der Detektionsschaltung (9) gelieferten Taktsignals (CLK4) in der Größenordnung von 666,6 Hz liegt, bei einer Breite der Samplingimpulse und der Phasensprünge von 32,5 ns.

## Claims

1. A full duplex transmission circuit of a signal encoded according to lines and frames and having synchronization words (SW) alternating with data words (2B+D), comprising a phase-locked loop (5), adapted to provide an emission clock signal (CLK2) synchronized with a reference frequency (CLK0) of the type including a frequency synchronizer and a frequency counter/divider; of sampling signal (CLK3) for an analog-to-digital converter (8), whose phase is locked on the phase shift (ϕ) between the emitted signal and the received signal being produced on the receive side using a clock signal (CLK1) provided to a decoder (12) by said loop synchronizer (5); **characterized in that** it comprises means, added to said frequency synchronizer (14) to multiply the frequency, so as to reduce the duration of possible phase skips of the sampling signal (CLK3), said means including in particular a logic gate (22) adapted to achieve a combination of the "Exclusive-OR" type of two signals (S1, S2), having their phases mutually shifted, and originating from a ring oscillator (16) of said frequency synchronizing and multiplying circuit (14'), the selection of the phase shift between the two outputs (S1, S2) of said ring oscillator (16) being achieved by a multiplexer (21').

2. The transmission circuit of claim 1, **characterized in that** said multiplexer controlled by a shift register (20) of the circulating "1" type.

3. The transmission circuit of claim 2, **characterized in that** said ring oscillator (16) includes n inverters (I(1)... I(i)... I(n)), biased by a current generated by a loop controlling the phase on the basis of a signal provided by a quartz (X); and wherein said multiplexer (21') includes two series of n switches (K(1)... K(i)... K(n); K'(1) ... K'(i) ... K' (n)), each respectively drawing an output (S1; S2) from the ring oscillator (16), the control of a switch (K(i)) of the first series, drawing the output signal (S1) of the oscillator (16) from an inverter (I(i)), corresponding to the control of a switch (K'(i+m)) of the second series which draws the output signal (S2) of the oscillator (16) from an inverter (I(i+m)) having, with respect to the output signal (S1), a delay corresponding to the propagation time of the signal in m inverters; and wherein said shift register (20) includes n flip-flops (B(1) ... B(j)... B(n)), the state of two adjacent flip-flops (B(j), B(j+1)) respectively constituting the control signal, in each series, of two non-adjacent switches (K(i),K(i+m/2); K'(i+m), K'(i+m+m/2)), so that the clock signal (CLK1) provided by the logic gate (22) has a frequency equal to twice the frequency of the quartz (X).

4. The transmission circuit of claim 2 or 3, **characterized in that** said shift register is controlled by the reference clock signal (CLK0); and wherein the shift of the state "1" from a flip-flop (B(j)) to the next (B(j+1)) or preceding (B(j-1)) flip-flop is controlled by a signal (AV/RET) generated by a comparator (13) of said phase-locked loop (5), to synchronize the clock signal (CLK1) of the decoder (12) on the reference clock signal (CLK0).

5. The transmission circuit of any of claims 1 to 4, **characterized in that** the decoder (12) provides the analog-to-digital converter (8) with said sampling signal (CLK3) using the result calculated by an arithmetic and logic unit (11'), which sums the value of said frequency counter/divider (15') of said phase-locked loop (5) with the value of a line delay counter (10'), the latter containing the value of the phase shift (ϕ) between the emitted signal and the received signal, its up/down counting frequency corresponding to the frequency of the synchronization words (SW) of the frame.

6. The transmission circuit of claim 5, **characterized in that** said line delay counter (10') receives at its clock input, a signal (CLK4) having, at each synchronization word (SW), a pulse whose duration corresponds to the duration of a received code, the occurrence frequency of said pulse corresponding to the frequency of the synchronization words (SW) on the frame, and receiving at its up/down counting input a signal ("e") indicating the presence and the direction of a phase error, said two signals (CLK4, "e") being provided by a circuit (9) for detecting the received data.

7. The transmission circuit of claim 6, **characterized in that** said pulse of said clock signal (CLK4) of the line delay counter (10') is provided upon the occurrence of the first code (SW(1)) of each synchronization word (SW).

8. The transmission circuit of any of claims 1 to 7, **characterized in that** the circuit is applied to the 160-kbit/s transmission of a line signal encoded in quaternary codes according to the 2B1Q standard.

9. The transmission circuit of claim 8, **characterized in that** said ring oscillator (16) includes nineteen inverters, said multiplexer (21') and said shift register (20) including two series of nineteen switches, and nineteen flip-flops, respectively, the phase shift between the two signals (S1, S2) corresponding to the propagation time in four inverters (I(i)); and wherein the emission (CLK2) and sampling (CLK3) frequencies are 80 kHz, the frequency of the clock signal (CLK1) of said decoder (12) being 30.72 MHz; and wherein the frequency of the clock signal (CLK4) provided by the detection circuit (9) is approximately 666.6 Hz, the duration of the sampling pulses and of the phase skips being 32.5 ns.
